# EUROPEAN PATENT APPLICATION

(11) **EP 4 567 150 A1**
(43) Date of publication of application: **11.06.2025**
(21) Application number: 24214173.7
(22) Date of filing: 20.11.2024
(51) Int. Cl.: C23C 16/448

(54) **FLOODING PREVENTION SYSTEM AND METHOD**

(30) Priority: 08.12.2023 FI 20236349
(71) Applicant: Picosun Oy, 02150 Espoo (FI)
(72) Inventor: HOLM, Niklas, 02430 Masala (FI); VÄHÄ-OJALA, Timo, 02430 Masala (FI)
(74) Representative: Espatent Oy

(57) **Abstract**

Herein is provided a precursor source system (100), comprising a source container (110), a filling line (210) comprising a filling inlet (201) configured for filling the source container (110) during use, a carrier gas line (220) comprising a carrier gas inlet (202) configured to discharge a carrier gas to a head space (120) of the source container (110), and an outlet line (230) comprising an outlet opening (203), wherein the carrier gas inlet (202) and the filling inlet (201) extend further into the source container relative to the outlet opening (203) to prevent flooding of precursor liquid into the outlet line (230).

## Description

### TECHNICAL FIELD

The present disclosure generally relates to the field of substrate processing. The disclosure relates particularly, though not exclusively, to a precursor source system in processing apparatus.

### BACKGROUND

This section illustrates useful background information without admission of any technique described herein representative of the state of the art.

Impurities in processing apparatuses may cause significant and irreparable harm due to the small size of the structures being fabricated. It may be harmful to processes, if undesired substances enter a reaction chamber or its in-feed lines. These undesired substances may originate from outside the processes, or from the processes themselves. For instance, if the reaction chamber is configured to operate with gases, invertedly letting liquids or solids enter the reaction chamber may be harmful.

### SUMMARY

The appended claims define the scope of protection. Any examples and technical descriptions of apparatuses, products and/or methods in the description and/or drawings not covered by the claims are presented not as embodiments of the invention but as background art or examples useful for understanding the invention.

It is an object of certain embodiments of the present disclosure to prevent undesired substances from entering a reaction chamber, or at least to provide an alternative solution to existing technology. Accordingly, certain disclosed embodiments provide for an ingenious apparatus and method for preventing flooding of precursor liquid from a source container.

According to a first example aspect of the invention there is provided a precursor source system, comprising:
a source container;
a filling line comprising a filling inlet configured for filling the source container during use;
a carrier gas line comprising a carrier gas inlet configured to discharge a carrier gas to a head space of the source container; and
an outlet line comprising an outlet opening,
wherein the carrier gas inlet and the filling inlet extend further into the source container relative to the outlet opening to prevent flooding of precursor liquid into the outlet line.

In certain embodiments, the carrier gas inlet and the filling inlet extend further (further down, in vertical direction, deeper) into the source container relative to the (location of the) outlet opening. In certain embodiments, the carrier gas inlet and the filling inlet extend into the source container at a greater relative depth (in vertical direction) than the outlet opening.

In certain embodiments, the filling inlet extends further into the source container relative to the outlet opening and relative to the carrier gas inlet. In certain embodiments, the filling inlet extends into the source container at a greater relative depth (in vertical direction) than the outlet opening and the carrier gas inlet. In certain embodiments, the outlet opening is located higher than (above, vertically higher) the carrier gas inlet to prevent flooding or overflowing of precursor liquid into the outlet line.

In certain embodiments, the precursor source system comprises a filling line leading to the filling inlet. In certain embodiments, the precursor source system comprises a filling line attached to the filling inlet. In certain embodiments, the precursor source system comprises a carrier gas line leading to the carrier gas inlet. In certain embodiments, the precursor source system comprises a carrier gas line attached to the carrier gas inlet. In certain embodiments, the precursor source system comprises an outlet line attached to the outlet opening. In certain embodiments, the filling inlet, the carrier gas inlet, and the outlet opening are positioned within the source container.

In certain embodiments, the source container comprises a plurality of filling lines. In certain embodiments, the source container comprises a plurality of carrier gas lines. In certain embodiments, the source container comprises a plurality of outlet lines. In these embodiments, the embodiments described herein in relation to one filling line, carrier gas line or an outlet line apply equally to plurality of each, respectively. The same applies to filling inlets, carrier gas inlets and outlet openings as well (if more than one).

Accordingly, in certain embodiments, an outlet opening (or an outlet opening closest to a bottom of the source container (i.e., lowest outlet opening), if more than one) resides at a (vertical) level that exceeds a (vertical) level at which carrier gas is discharged into (the head space of) the source container.

In certain embodiments, the filling line enters the source container via a lid or top part of the source container. In certain embodiments, an endpoint of the filling line forms the filling inlet. In certain embodiments, the endpoint of the filling line extends further (in vertical direction) into (a body of liquid housed in) the source container relative to carrier gas inlet and outlet opening (within the source container). In certain embodiments, the precursor source system further comprises a filling line, wherein the endpoint of the filling line forms the filling inlet.

In certain embodiments, the carrier gas line enters the source container via a lid or top part of the source container. In certain embodiments, an endpoint of the carrier gas line forms the carrier gas inlet. In certain embodiments, the endpoint of the carrier gas line extends further (in vertical direction) into the source container relative to the outlet opening. In certain embodiments, the precursor source system further comprises a carrier gas line, wherein the endpoint of the carrier gas line forms the carrier gas inlet.

In certain embodiments, the opening of the outlet line is positioned at a mouth of the outlet line. In certain embodiments, the outlet line enters the source container via a lid or top part of the source container. In certain embodiments, an endpoint of the outlet line forms the outlet opening. In certain embodiments, the filling line, the carrier gas line, and the outlet line enter the source container via a lid or top part of the source container. In certain embodiments, the line(s) are in the form of pipes or tubular channels.

In certain embodiments, the precursor source system comprises a level sensor. In certain embodiments, the level sensor is configured to determine the level of the precursor liquid inside the source container. In certain embodiments, the precursor source system comprises the level sensor configured to determine a need for filling the source container. In certain embodiments, the level sensor is an ultrasonic level sensor.

In certain embodiments, the carrier gas line comprises a pressure sensor. In certain embodiments, the pressure sensor is configured to measure pressure of the carrier gas line. In certain embodiments, the pressure sensor is configured to indirectly measure pressure of the source container. In certain embodiments, the pressure sensor is configured to indirectly measure pressure of the precursor source system.

In certain embodiments, the pressure sensor is configured to measure a change in pressure. In certain embodiments, the pressure sensor is configured to measure an increase in pressure. In certain embodiments, the pressure sensor is configured to measure pressure as a function of time. In certain embodiments, the pressure sensor is configured to measure pressure as a function of any process variable, such as temperature. In certain embodiments, the pressure sensor is configured to measure pressure as a function of processing stages.

In certain embodiments, the carrier gas line comprises a pressure sensor configured to indirectly determine a level of precursor liquid inside the source container when the level of precursor liquid is over a predetermined maximum filling level. In certain embodiments, the precursor source system is configured to provide indication(s) of the level of precursor liquid inside the source container when the level of precursor liquid is over a predetermined maximum filling level. In certain embodiments, said indication(s) is/are provided by the level sensor. In certain embodiments, said indication(s) are provided by measuring the pressure of the carrier gas line via the pressure sensor.

In certain embodiments, when the level of the precursor liquid is at the level of the carrier gas inlet in the source container, the pressure sensor shows an increase in pressure. In certain embodiments, when the level of the precursor liquid is above (higher, vertically higher) the level of the carrier gas inlet in the source container, the pressure sensor shows an even higher increase in pressure. In certain embodiments, when the level of the precursor liquid is higher in relation to the (vertical) level of the carrier gas inlet in the source container, the pressure sensor shows an even higher increase in pressure.

In certain embodiments, the pressure provide(s) indication(s) of the level of the precursor liquid in the source container. In certain embodiments, the larger the pressure of the carrier gas line, the higher the level of the precursor liquid in the source container.

In certain embodiments, the source container comprises a head space and a body of liquid. In certain embodiments, a surface of the liquid separates the head space and the body of liquid. In certain embodiments, the carrier gas inlet is configured to discharge carrier gas into the head space of the source container.

In certain embodiments, the source container comprises precursor liquid. In certain embodiments, the precursor liquid forms the body of liquid. In certain embodiments, the precursor liquid is configured to evaporate from the surface of the precursor liquid. In certain embodiments, said evaporation occurs into the head space of the source container. In certain embodiments, the carrier gas is configured to mix with the evaporated precursor gas. In certain embodiments, the carrier gas is configured to carry the evaporated precursor gas. In certain embodiments, the outlet line is configured to deliver the evaporated precursor gas carried by carrier gas to a reaction chamber.

In certain embodiments, the precursor liquid is configured to vaporize from the surface of the precursor liquid. In certain embodiments, said vaporization occurs into the head space of the source container. In certain embodiments, the carrier gas is configured to mix with the vaporized precursor gas. In certain embodiments, the carrier gas is configured to carry the vaporized precursor gas. In certain embodiments, the outlet line is configured to deliver the vaporized precursor gas carried by carrier gas to a reaction chamber.

According to a second example aspect of the invention there is provided a method for preventing flooding (overfilling, overflowing) of precursor liquid into the outlet line through monitoring the pressure of a carrier gas line leading to the carrier gas inlet in a precursor source system according to the first aspect.

In certain embodiments, said monitoring comprises measuring pressure of the carrier gas line. In certain embodiments, said monitoring comprises measuring the pressure of the carrier gas line by the pressure sensor.

In certain embodiments, the method comprises detecting a risk of flooding (overfilling, overflowing) of precursor liquid into the outlet line based on said monitoring. In certain embodiments, said detecting the risk comprises measuring an increase in pressure by the pressure sensor. In certain embodiments, said risk of flooding of precursor liquid into the outlet line comprises the level of the precursor liquid rising in the source container above the predetermined maximum filling level.

In certain embodiments, as a response to said detecting the risk of flooding of precursor liquid into the outlet line based on said monitoring, an alarm is provided (to an operator).

According to a third example aspect of the invention there is provided a semiconductor processing apparatus, comprising the precursor source system according to the first aspect.

In certain embodiments, the semiconductor processing apparatus is a thin film deposition apparatus. In certain embodiments, the semiconductor processing apparatus is a chemical vapour deposition (CVD) apparatus. In certain embodiments, the semiconductor processing apparatus is an atomic layer deposition (ALD) apparatus. In certain embodiments, the semiconductor processing apparatus is an etching apparatus.

According to a fourth example aspect of the invention there is provided an apparatus comprising at least one processor, and at least one memory including computer program code (or a computer program), wherein the at least one memory and the computer program code (or computer program) are configured, with the at least one processor, to cause the apparatus to perform the method according to the second example aspect.

According to a fifth example aspect of the invention there is provided a computer program comprising computer executable program code which when executed by a processor causes an apparatus to perform the method according to the second example aspect.

On certain occasions, the filling line or inlet is (are) arranged differently, or independently of the carrier gas line and inlet and the outlet line and opening. Accordingly, in accordance with a further example aspect of the invention, there is provided a precursor source system, comprising: a source container; a filling line comprising a filling inlet configured for filling the source container during use; a carrier gas line comprising a carrier gas inlet configured to discharge a carrier gas to a head space of the source container; and an outlet line comprising an outlet opening, wherein the carrier gas inlet extends further into the source container relative to the outlet opening to prevent flooding of precursor liquid into the outlet line. In certain embodiments, the carrier gas inlet extends into the source container at a greater relative depth than the outlet opening.

In accordance with further embodiments, embodiments of the further example aspect are provided, the embodiments comprising subject matter of any single embodiment presented in connection with the first aspect, or the embodiments comprising subject matter of any of the embodiments presented in connection with the first aspect combined with subject matter presented in any other embodiment or embodiments.

Different non-binding example aspects and embodiments have been illustrated in the foregoing. The embodiments in the foregoing are used merely to explain selected aspects or steps that may be utilized in different implementations. Some embodiments may be presented only with reference to certain example aspects. It should be appreciated that corresponding embodiments may apply to other example aspects as well. In particular, the embodiments described in the context of the first aspect are applicable to each further aspect. Any appropriate combinations of the embodiments may be formed.

### BRIEF DESCRIPTION OF THE FIGURES

Some example embodiments will be described with reference to the accompanying figures, in which:
Fig. 1a schematically shows a first situation of a precursor source system according to an example embodiment;
Fig. 1b schematically shows a second situation of a precursor source system according to an example embodiment;
Fig. 1c schematically shows a third situation of a precursor source system according to an embodiment;
Fig. 1d schematically shows a fourth situation of a precursor source system according to an embodiment;
Fig. 2 schematically shows an apparatus according to an example embodiment; and
Fig. 3 shows a system in accordance with certain embodiments.

### DETAILED DESCRIPTION

In the following description, like reference signs denote like elements or steps.

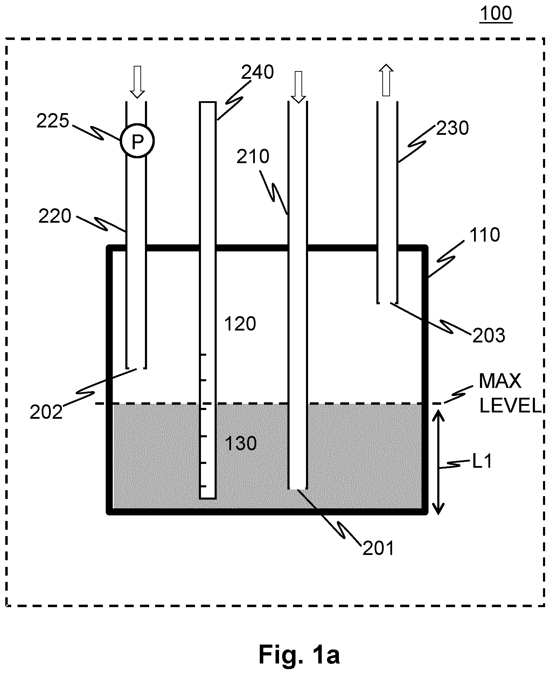

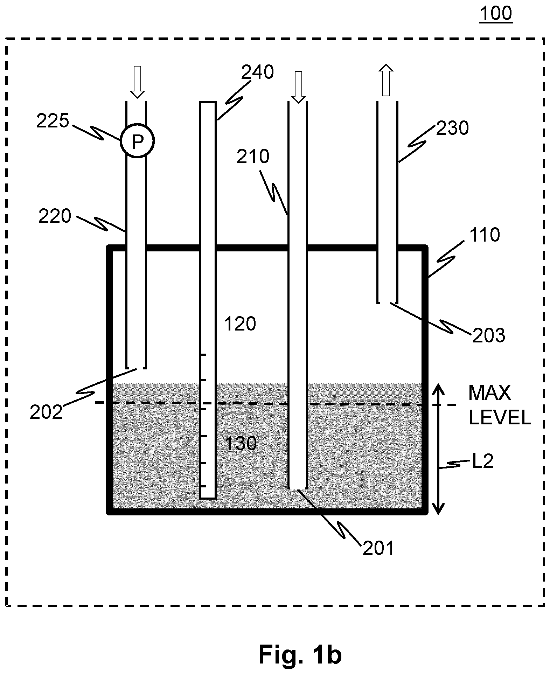

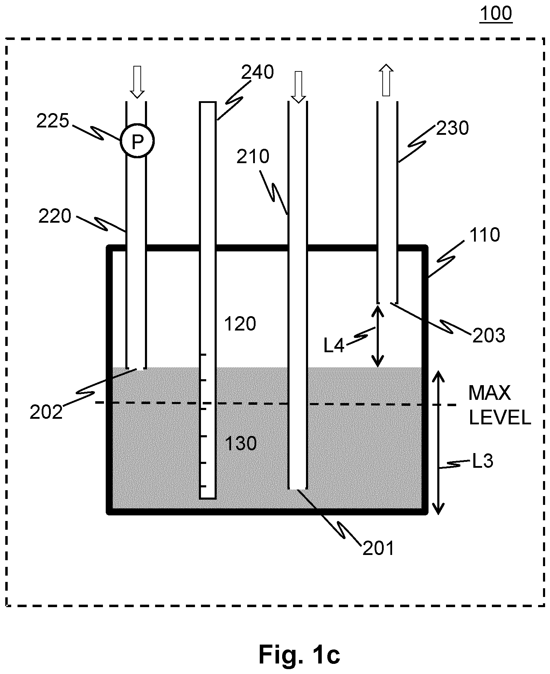

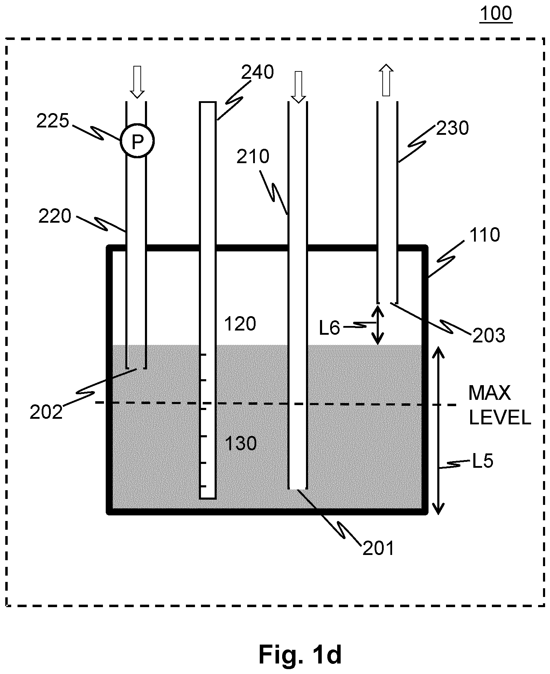

Figs. 1a, 1b, 1c and 1d present four example situations of a precursor source system 100 according to an example embodiment. The precursor source system 100 comprises a source container 110. The source container 110 is a bottle, an ampoule, a reservoir, a chamber, a tank, or any suitable container to hold precursor chemical(s). In certain embodiments, the source container 110 is a (one) partitionless space (enclosure). In certain embodiments, the source container 110 comprises no dividing walls (to divide the source container 110 into smaller sections) within itself. The source container 110 comprises a head space 120 and a body of liquid 130. A surface of the liquid separates the head space 120 and the body of liquid 130. The head space 120 and the body of liquid 130 each have variable volume that depends on the volume of the other. The body of liquid 130 is precursor liquid, precursor chemical or any other liquid suitable to be used in processing.

The precursor liquid resides in the source container 110. The precursor liquid is configured to vaporize and/or evaporate from the surface of the precursor liquid. In certain embodiments, the precursor liquid is configured to vaporize and/or evaporate in the source container 110. When said vaporization and/or evaporation occurs, precursor gas is formed in the head space 120 of the source container 110. Optionally, the source container is heated.

The precursor source system 100 comprises a filling inlet 201. In certain embodiments, the precursor source system 100 further comprises a filling line 210 leading to the filling inlet 201.ln certain embodiments, the filling line 210 enters the source container 110 via a lid or top part of the source container 100. The filling line 210 is configured to deliver precursor liquid to the source container 110. The filling inlet 201 is configured to fill the source container 110 during use. In certain embodiments, the said "during use" is understood to mean "without removing, filling and replacing the source container 100". In certain embodiments, said "filling the source container 110 during use" is understood to mean that the source container 110 stays operational throughout during processing. There is no need to remove the source container 110 for re-filling.

The precursor source system 100 comprises a carrier gas inlet 202. In certain embodiments, the precursor source system 100 further comprises a carrier gas line 220 leading to the carrier gas inlet 202. In certain embodiments, the carrier gas line 220 enters the source container 100 via a lid or top part of the source container 100. The carrier gas line 220 is configured to deliver carrier gas to the source container 110. The carrier gas inlet 202 is configured to discharge a carrier gas to a head space 120 of the source container 110.

Preferably, the carrier gas inlet 202 is located above (higher in relation to) the surface of liquid in the source container 110. Preferably, the carrier gas inlet 202 is located at a vertically higher location relative (in comparison) to the surface of liquid in the source container 110.

In certain embodiments, the carrier gas line 220 comprises a pressure sensor 225. In certain embodiments, the pressure sensor 225 is configured to (indirectly) measure pressure of the source container 110. In certain embodiments, the pressure sensor 225 is configured to measure a change in pressure, such as an increase in pressure. In certain embodiments, the pressure sensor 225 is configured to measure pressure as a function of time, or as a function of any process variable, such as temperature. In certain embodiments, the pressure sensor 225 is configured to measure all the preceding simultaneously. The pressure sensor 225 is configured to (indirectly) to determine a level of precursor liquid inside the source container 110.

The precursor source system 100 comprises an outlet opening 203. The outlet opening 203 is attached to the outlet line 230. In certain embodiments, the outlet line 230 enters the source container 100 via a lid or top part of the source container 100.

The Figs. 1a, 1b, 1c and 1 d illustrate the vertical locations of the outlet opening 203 and the carrier gas inlet 202. In certain embodiments, the outlet opening 203 is located in a vertically higher location (above) than the carrier gas inlet 202, such that the outlet opening 203 penetrates less within the source than the carrier gas inlet 202 and the filling inlet 201. Mentioned relative height arrangement resulting in the effect of preventing flooding of precursor liquid into an outlet line 230. In certain embodiments, the carrier gas inlet 202 and the filling inlet 201 extend further into the source container 110 relative to the outlet opening 203. In certain embodiments, the filling inlet 201 extends yet further into the source container 110 relative to both the outlet opening 203 and the carrier gas inlet 202. The outlet line 230 is configured to deliver the precursor gas carried by carrier gas to the reaction chamber.

In certain embodiments, the precursor source system 100 comprises a level sensor 240. In certain embodiments, the level sensor 240 is an ultrasonic level sensor. The level sensor 240 is configured to provide primary information on the level of the precursor liquid in the source container 110. The level sensor 240 is configured to determine need for filling the source container 110.

In certain embodiments, the precursor source system 100 is configured to provide secondary information on the level of the precursor liquid in the source container 110 using the pressure provided by the pressure sensor 225.

A first example situation of a precursor source system according to an example embodiment is shown in Fig. 1a. The source container 100 is filled with the precursor liquid to the predetermined maximum filling level (MAX LEVEL). This is shown as L1 level of precursor liquid.

In the ideal (normal, optimal) operation of the precursor source system 100, the level of precursor liquid does not exceed the predetermined maximum filling level (MAX LEVEL). In certain embodiments, the level sensor 240 is configured to determine a need for filling the source container 110, when the level of the precursor liquid falls below the predetermined maximum filling level (MAX LEVEL) during processing.

However, there are situations when the precursor source system 100 does not operate ideally. This may occur for instance due to level sensor 240 failure. According to a second example situation shown in Fig. 1b, the level of precursor liquid has risen above said predetermined maximum filling level (MAX LEVEL) in the source container 110. This is shown as L2 level of precursor liquid.

A third example situation is shown in Fig. 1c. In this third situation, the level sensing and determining need for filling the source container 110 via the level sensor 240 may have failed. The level of precursor liquid L3 has risen at the carrier gas inlet 202.

The prevention of flooding of precursor liquid into the outlet line 230 is illustrated in Fig. 1c via vertical height difference L4. The vertical height difference L4 shows that the outlet opening 203 is arranged higher (above) in relation to the carrier gas inlet 202 to prevent flooding of precursor liquid into an outlet line 230.

A fourth example situation is shown in Fig. 1d. The level of precursor liquid L5 has risen higher than (above the level of) the carrier gas inlet 202.

The prevention of flooding of precursor liquid into the outlet line 230 is illustrated in Fig. 1d via vertical height difference L6. The vertical height difference L6 shows that the outlet opening 203 is arranged higher (above) in relation to the carrier gas inlet 202 to prevent flooding of precursor liquid into an outlet line 230.

In certain embodiments, the pressure sensor 225 measures an increase in pressure, when the level of the precursor liquid is at the level of the carrier gas inlet 202 in the source container 110 (Fig. 1c). In certain embodiments, the pressure sensor 225 measures even higher increase in pressure, when the level of the precursor liquid is higher than (above) the level of the carrier gas inlet 202 in the source container 110 (Fig. 1d). In certain embodiments, the pressure sensor 225 measures a pressure increase, when the level of the precursor liquid rises at the level of the carrier gas inlet 202, or higher than (above) the level of the carrier gas inlet 202.

Further, there is provided a method for preventing flooding of precursor liquid into the outlet line 230 through monitoring the pressure of the carrier gas line 220 leading to a carrier gas inlet 202 in a precursor source system 100 in accordance with certain embodiments.

In certain embodiments, the monitoring comprises measuring the pressure of the carrier gas line 220 by the pressure sensor 225. In certain embodiments, the monitoring comprises measuring the pressure of the carrier gas line 220 in a continuous manner or by a predetermined time interval. In certain embodiments, the method comprises detecting a risk of flooding of precursor liquid into the outlet line 230 based on said monitoring.

Even if the level of precursor liquid rises higher than (above) the predetermined maximum filling level (MAX LEVEL) inside the source container 110, due to, for instance, a level sensor 240 malfunction, the ingenious manner of arranging the carrier gas inlet 202 further into the source container 110 in relation to the outlet opening 203 and monitoring of the pressure of the carrier gas line 220 leading to a carrier gas inlet 202 in a precursor source system 100 enables prevention of flooding and maintaining the precursor liquid inside the source container 110 until the situation is fixed or until any necessary actions are performed to return to normal operation of the precursor source system 100.

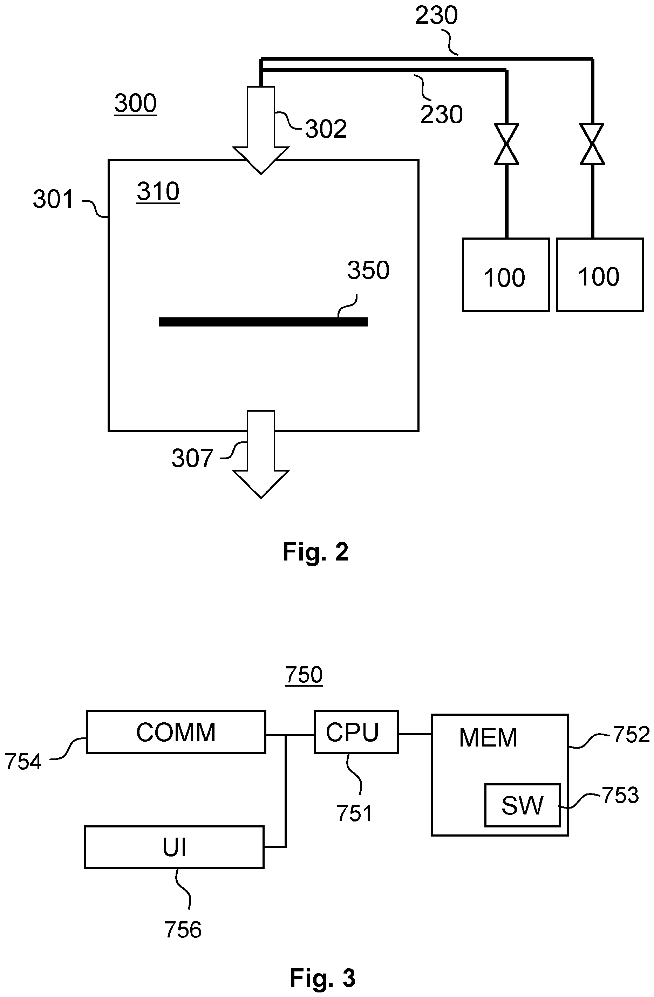

Fig. 2 schematically shows an apparatus 300, such as a semiconductor processing apparatus, such as a thin film deposition apparatus, comprising the disclosed precursor source system in accordance with certain embodiments. According to certain embodiments, the apparatus is an ALD reactor, CVD reactor or another type of deposition or etching apparatus.

The apparatus 300 comprises a reaction chamber 301, the reaction chamber 301 enclosing a reaction space 310. In certain embodiments, the reaction space 310 is heated. The reaction chamber 301 houses a substrate 350, or a plurality of substrates. Precursor is fed into the reaction chamber 301 through a reaction chamber inlet 302. The precursor gas is fed into the reaction chamber inlet 302 via a precursor source system outlet line 230 (outlet line 230 in Figs. 1a, 1b, 1c and 1d) from the precursor source system 100. The precursor source system outlet line 230 extends (attaches) to the reaction chamber inlet 302.

In certain embodiments, the apparatus 300 comprises a plurality of precursor source systems 100. Preferably, the precursor gases are fed into the reaction chamber inlet 302 via individual precursor system outlet lines 230 from individual precursor source systems 100. In the event of ALD processing, the precursor gases are fed alternately. In certain embodiments, the excess precursor gas(es) exit the reaction chamber 301 via an exhaust line 307. In an embodiment, the in-feed of the precursor gases is from a top portion of the reaction chamber 301 and the exhaust is from the bottom of the reaction chamber 301. In certain embodiments, the reaction chamber 301 is a vertical flow chamber.

Fig. 3 shows a block diagram of a computerized control system of a source container or a deposition apparatus in accordance with certain example embodiments. The control system 750 comprises at least one processor 751 to control the operation of the apparatus and at least one memory 752 comprising a computer program or software 753. The software 753 includes instructions or a program code to be executed by the at least one processor 751 to control the apparatus. The software 753 may typically comprise an operating system and different applications. In certain embodiments, the control system 750 is configured as a computerized system, which uses one or more computers.

The at least one memory 752 may form part of the apparatus or it may comprise an attachable module. The control system 750 further comprises at least one communication unit 754. The communication unit 754 provides for an interface for internal communication of the deposition apparatus. In certain embodiments, the control unit 750 uses the communication unit 754 to send instructions or commands to pressure sensor(s), source container(s), valves, and other adjustment devices (not shown). In certain embodiments, the control unit 750 uses the communication unit 754 to receive data from different parts of the apparatus. In certain preferred embodiments, the control unit 750 uses the communication unit 754 to receive pressure measurement data from the pressure sensor 225 of the carrier gas line 220.

The control system 750 may further comprise a user interface 756 to co-operate with an operator, for example, to receive input such as process parameters from the operator. In certain embodiments, the user interface 756 is connected to the at least one processor 751.

As to the operation of the apparatus, the control system 750 controls e.g. the filling of the source container 110 through the filling inlet 201 during use, discharging carrier gas through a carrier gas inlet 202 to the head space 120 of the source container 110, and delivering vaporized and/or evaporated precursor gas carried by carrier gas to the reaction chamber via the outlet line 230. In certain embodiments, the filling of the source container 110 through the filling inlet 201 during use is controlled by controlling a valve (not shown) of the filling line 210. In certain embodiments, the discharging carrier gas through a carrier gas inlet 202 to the head space 120 of the source container 110 is controlled by controlling a valve (not shown) of the carrier gas line 220. In certain embodiments, the software 753 (a computer program) with the at least one processor 751 are configured to determine the level of precursor liquid in the source container 110 based on the pressure measurement data received. In certain embodiments, the pressure measurement data is received from the pressure sensor 225 of the carrier gas line 220.

Without limiting the scope and the interpretation of the patent claims, certain technical effects of one or more of the example embodiments disclosed herein are listed in the following. A technical effect of the invention is prevention of flooding of the precursor liquid to the outlet line, and eventually to the reaction chamber of a processing apparatus. A further technical effect is maintaining the reaction chamber cleaner throughout the processing. A further technical effect is providing less defects in the final product caused by fouled reaction chamber. A further technical effect is providing better final product quality due to less defects in the final product caused by fouled reaction chamber. A further technical effect is providing secondary sensing means for determining the level of precursor liquid in the source container via pressure measurements conducted in the carrier gas line when the level of precursor liquid is at or above the predetermined maximum filling level, the primary sensing being the level sensor. A further technical effect is prevention of flooding of the precursor liquid to the outlet line, and eventually to the reaction chamber of a processing apparatus even if the level sensor fails. A further technical effect is prevention of flooding of the precursor liquid to the outlet line through monitoring the pressure of a carrier gas line.

Various embodiments have been presented. It should be appreciated that in this document, words comprise, include, and contain are each used as open-ended expressions with no intended exclusivity. The foregoing description has provided by way of non-limiting examples of particular implementations and embodiments a full and informative description of the best mode presently contemplated by the inventors for carrying out the invention. It is however clear to a person skilled in the art that the invention is not restricted to details of the embodiments presented in the foregoing, but that it can be implemented in other embodiments using equivalent means or in different combinations of embodiments without deviating from the characteristics of the invention.

Furthermore, some of the features of the afore-disclosed example embodiments may be used to advantage without the corresponding use of other features. As such, the foregoing description shall be considered as merely illustrative of the principles of the present invention, and not in limitation thereof. Hence, the scope of the invention is only restricted by the appended patent claims.

## Claims

1. A precursor source system (100), comprising:
a source container (110);
a filling line (210) comprising a filling inlet (201) configured for filling the source container (110) during use;
a carrier gas line (220) comprising a carrier gas inlet (202) configured to discharge a carrier gas to a head space (120) of the source container (110); and
an outlet line (230) comprising an outlet opening (203),
wherein the carrier gas inlet (202) and the filling inlet (201) extend further into the source container relative to the outlet opening (203) to prevent flooding of precursor liquid into the outlet line (230).

2. The precursor source system of claim 1, wherein the filling line (210), the carrier gas line (220) and the outlet line (230) enter the source container (110) via a lid or top part of the source container (110).

3. The precursor source system of claim 1 or 2, configured to provide indication(s) of the level of precursor liquid inside the source container (110) when the level of precursor liquid is over a predetermined maximum filling level.

4. The precursor source system of any preceding claim, wherein the carrier gas line (220) comprises a pressure sensor (225) configured to measure pressure of the carrier gas line (220).

5. The precursor source system of any preceding claim, further comprising a level sensor (240) configured to determine a need for filling the source container (110).

6. The precursor source system of claim 5, wherein the level sensor (240) is an ultrasonic level sensor.

7. The precursor source system of any preceding claim, wherein the filling inlet (201) extend further into the source container relative to the outlet opening (203) and relative to the carrier gas inlet (202).

8. A method for preventing flooding of precursor liquid into an outlet line (230) through monitoring the pressure of a carrier gas line (220) leading to the carrier gas inlet (202) in a precursor source system of any of claims 1-7.

9. The method of claim 8, comprising detecting a risk of flooding of precursor liquid into the outlet line based on said monitoring.

10. A semiconductor processing apparatus (300), comprising the precursor source system (100) of any of claims 1-7.

11. An apparatus comprising at least one processor (751), and at least one memory (752) including computer program code (753), wherein the at least one memory (752) and the computer program code (753) are configured, with the at least one processor (751), to cause the apparatus to perform the method according claim 8 or 9.

12. A computer program comprising computer executable program code (753) which when executed by a processor (751) causes an apparatus to perform the method according to claim 8 or 9.
